**Europäisches Patentamt**

(19) **European Patent Office**

**Office européen des brevets**

(11) Veröffentlichungsnummer: **0 025 894**
**B1**

(12) **EUROPÄISCHE PATENTSCHRIFT**

(45) Veröffentlichungstag der Patentschrift:
27.07.83

(21) Anmeldenummer: 80105129.3

(22) Anmeldetag: 28.08.80

(51) Int. Cl.³: **H 03 B 19/14,** H 03 B 5/18

(54) **Frequenzteiler.**

(30) Priorität: 20.09.79 DE 2937994

(43) Veröffentlichungstag der Anmeldung:
01.04.81 Patentblatt 81/13

(45) Bekanntmachung des Hinweises auf die Patenterteilung:
27.07.83 Patentblatt 83/30

(84) Benannte Vertragsstaaten:
AT BE CH DE FR GB IT LI LU NL SE

(56) Entgegenhaltungen:
DE-A-1 811 966
DE-A-2 124 650
FR-A-961 770
US-A-2 544 407
US-A-3 089 040
US-A-3 832 651
**ELECTRONIC DESIGN, Band 19, Nr. 16, 5. August
1971 ROCHELLE PARK (US) M. TURNER: »1-GHz
oscillator can be made with an FET and
microstrips«, Seiten 60 und 62.
7TH EUROPEAN MICROWAVE CONFERENCE 5.
bis 8. September 1977, Copenhagen. Microwave
Exhibitions and Publications Ltd. LONDON (GB)
J. NOORDANUS: »Hybrid M. I. C. digital frequency dividers et 4,5 and 9 GHz«, Seiten 198—202**

(73) Patentinhaber: **SIEMENS AKTIENGESELLSCHAFT,
Berlin und München Wittelsbacherplatz 2,
D-8000 München 2 (DE)**

(72) Erfinder: **Ulmer, Wolfgang, Dipl.-Ing., Grünstrasse 9,
D-8000 München 70 (DE)**
Erfinder: **Schröcker, Anton, Dipl.-Ing.,
Rolf-Pinegger-Strasse 7, D-8000 München 21 (DE)**

Frequenzteiler

Die Erfindung bezieht sich auf einen Frequenzteiler für den Bereich sehr kurzer elektromagnetischer Wellen mit einem oberwellensynchronisierten Oszillator mit einem verstärkenden Halbleiterelement. Ein solcher Frequenzteiler ist durch die Literaturstelle »Instruments and Experimental Technique, Vol. 17, No. 5, Pt. Seite 1365—1366, Sept./Okt. 1974 (veröff. Februar 1975)« bekannt.

Frequenzteiler werden bei einer Vielzahl von Geräten der elektrischen Nachrichtentechnik benötigt, beispielsweise innerhalb von Frequenzregelschaltungen von Trägerversorgungen. Durch die Frequenzteiler wird die Nachstimmung in eine Ebene niederer Frequenz gebracht. Dies ergibt eine Vereinfachung gegenüber dem Verfahren, bei dem eine Quarzfrequenz vervielfacht und die Oszillatorfrequenz in der RF-Ebene mittels der vervielfachten Quarzfrequenz stabilisiert wird.

Als Frequenzteiler können bis zu Frequenzen von ca. 1,5 GHz digitale Frequenzteiler eingesetzt werden. Für höhere Frequenzen werden Frequenzteiler mit Varaktordioden oder mit oberwellensynchronisierten Oszillatoren eingesetzt. Durch den Aufsatz »Hybrid MIC digital frequency dividers at 4,5 and 9 GHz« von J. Noordanus aus »Adv. Dev. Radio Dept. of Philips' Telecommunicatie Industrie«, erschienen anläßlich der European Microwave Conference 1977, ist es bekannt, die Frequenzteilung im RF-Bereich durch Synchronisation von Multivibratoren mit einer harmonischen Frequenz durchzuführen. Ferner ist durch die DE-B-2 124 650 eine Frequenzteilerschaltung mit Tunneldioden bekannt. Die bekannten Teilerschaltungen sind jedoch aufwendig und unzureichend hinsichtlich des Synchronisationsbereichs.

Der Erfindung liegt die Aufgabe zugrunde, einen Frequenzteiler einfachen Aufbaus zu schaffen, der innerhalb einer möglichst großen Bandbreite und mit einer möglichst kleinen Steuerleistung einen vorgegebenen Teilungsfaktor einhält.

Diese Aufgabe wird gemäß der Erfindung in der Weise gelöst, daß im Rückkopplungsweg vom Ausgang zum Eingang des Verstärkerelementes ein mit einem Kopplungskondensator in Reihe geschaltetes Leitungsstück solcher Länge eingeschaltet ist, daß bei der geteilten Frequenz die Phasendrehung der rückgekoppelten Schwingung durch das Verstärkerelement auf einen Wert von 360° ergänzt wird, und im Ausgangskreis des Verstärkerelementes ein Serienresonanzkreis eingeschaltet ist, dessen Resonanzfrequenz etwa in Bandmitte der geteilten Frequenz liegt.

Zur Erzielung einer Gesamtphasendrehung von 360° ist die Einschaltung eines Leitungsstückes entsprechender Längenabmessung im Rückkopplungsweg vom Ausgang zum Eingang eines Verstärkerelements durch die DE-A-1 811 966 bekannt, in der ein Mikrowellengenerator mit einem verstärkenden Halbleiterelement beschrieben wird.

Durch die US-A-3 089 040 ist es bei einem Frequenzteiler nach dem Prinzip der Impulsaustastung bekannt, im Rückkopplungsweg vom Ausgang zum Eingang des Verstärkerelements einen Koppelkondensator in Reihe mit einem Leitungsstück zu schalten.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen

Fig. 1 und 2 in einem vereinfachten Schaltbild jeweils einen Transistoroszillator mit einem Leitungsstück im Rückkopplungsweg,

Fig. 3 das Schaltbild des Transistoroszillators mit geöffneter Rückkopplungsschleife und

Fig. 4 in einer grafischen Darstellung die Phasenbeziehungen zwischen verschiedenen Punkten der Schaltung bei geöffneter Rückkopplungsschleife.

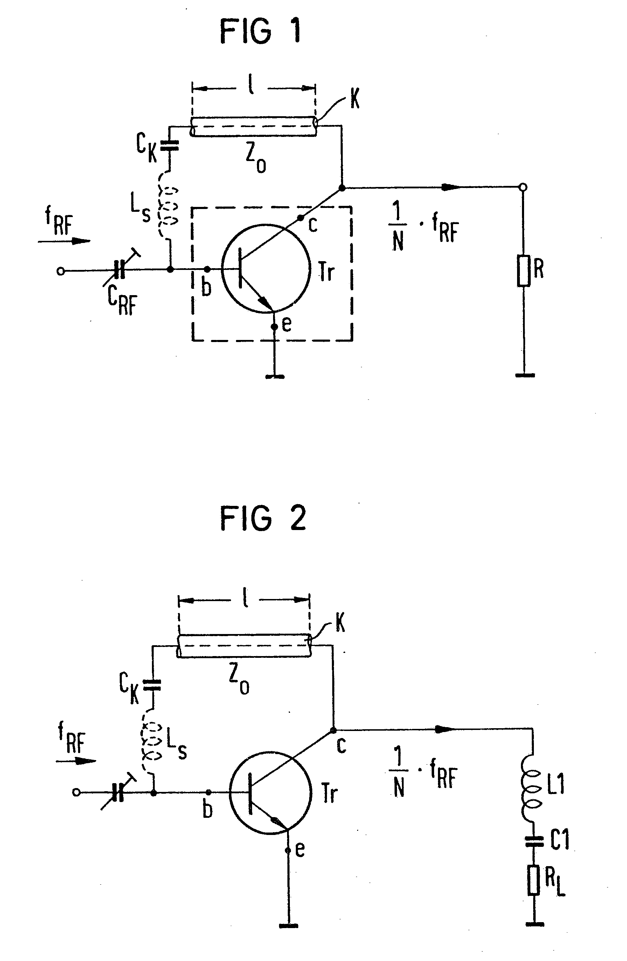

Fig. 1 zeigt eine Oszillatorschaltung mit einem Transistor Tr in Emittergrundschaltung. Die einzelnen Anschlüsse des in einem strichlierten Kästchen angeordneten Transistors Tr sind mit c, b, e bezeichnet. Im Rückkopplungsweg des Transistors zwischen dem Kollektor und der Basis ist ein Leitungsstück K der Länge l und der Impedanz $Z_0$ eingeschaltet, zu dem ein insbesondere variabler Koppelkondensator $C_K$ in Reihe geschaltet ist. Die strichliert eingezeichnete Spule $L_S$ stellt die Streuinduktivität der Schaltung dar. Der Koppelkondensator $C_K$ dient sowohl zum Sperren des Gleichstroms als auch zur Kompensation der Zuleitungsinduktivität $L_b$ des Transistors Tr und der Streuinduktivität $L_S$ der Schaltung. $L_S$ und $L_B$ sollen möglichst klein sein, da dieser Serienkreis eine die Synchronisationsbandbreite einschränkende Wirkung hat. Am Schaltungseingang des Oszillators wird die zu teilende RF-Frequenz $f_{RF}$ (Radio-Frequenz) über einen Kondensator $C_{RF}$ (Trimmer) zugeführt, dessen Kapazitätswert so klein ist, daß er für die Oszillatorschwingung bei der geteilten Frequenz zu vernachlässigen ist. Das in der Frequenz um den Faktor N geteilte Signal wird am Kollektor des Transistors Tr abgenommen und auf den ausgangsseitigen Lastwiderstand R gegeben.

Die Länge l des Leitungsstückes K ist so bemessen, daß die gesamte Phasenbeziehung einen Wert von 360° erreicht. Das Leitungsstück ergänzt somit die Phasendrehung der rückgekoppelten Schwingung durch das Verstärkerelement auf einen Wert von 360°. Bei dieser Drehung der rückgekoppelten Schwingung ist die Schwingbedingung des Oszillators erfüllt.

Fig. 2 zeigt eine dem Oszillator nach Fig. 1 weitgehend entsprechende Ausführungsform, jedoch ist hierbei im Ausgangskreis in Serie zum Lastwiderstand R$_L$ ein Serienresonanzkreis aus der Induktivität L1 und der Kapazität C1 geschaltet, dessen Resonanzfrequenz etwa in Bandmitte der geteilten Frequenz liegt. Diese Maßnahme bewirkt eine weitere Vergrößerung der Synchronisationsbandbreite.

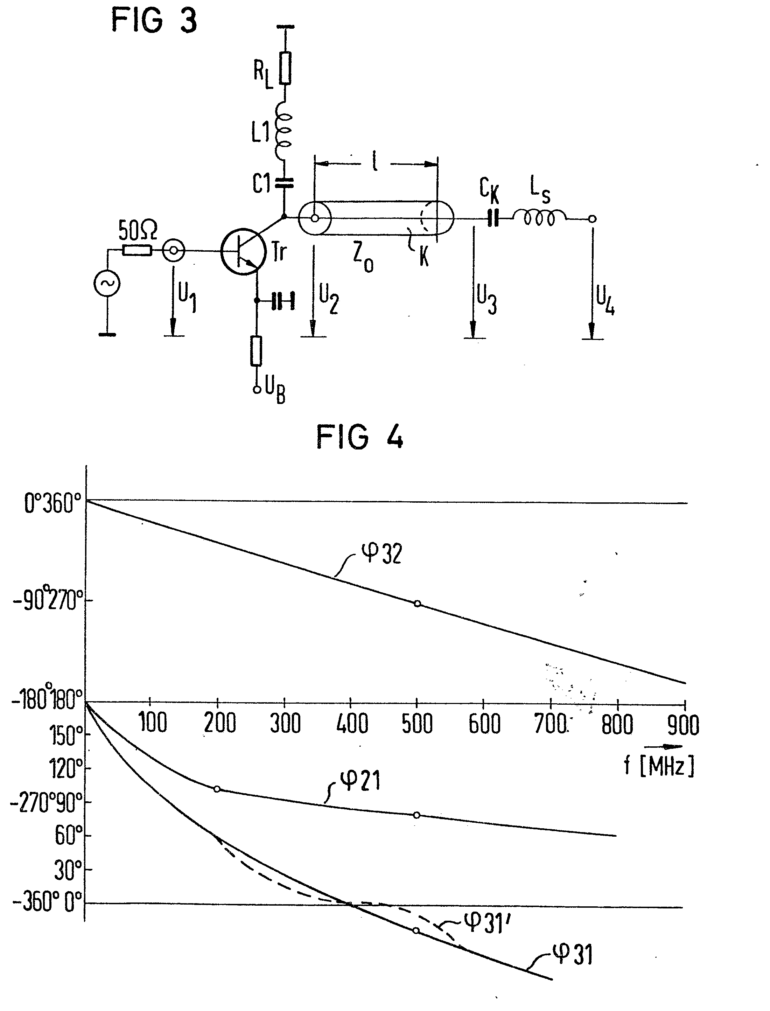

Fig. 3 zeigt die Oszillatorschaltung nach Fig. 2 bei geöffneter Rückkopplungsschleife, die der grafischen Darstellung der Phasenbeziehungen gemäß Fig. 4 zugrunde liegt. In der Schaltung sind die Spannungen U1, U2, U3 und U4 eingezeichnet, die die Spannung am Basisanschluß des Transistors Tr, den beiden Enden des Leitungsstücks K und am Ausgang der Schaltung, jeweils bezogen auf den Schaltungsnullpunkt, darstellen. Der Phasenwinkel zwischen der Spannung U2 und U1 ist mit $\varphi21$ bezeichnet, der Phasenwinkel zwischen der Spannung U3 und U2 mit $\varphi32$. Der Phasenwinkel $\varphi31$ zwischen der Spannung U3 und U1 stellt die Summe der Phasenwinkel $\varphi21$ und $\varphi32$ dar.

In Fig. 4 sind die Phasenwinkel $\varphi21$, $\varphi32$ und $\varphi31$ jeweils über der Frequenz f aufgetragen. In die Kurve für den resultierenden Phasenwinkel $\varphi31$ ist zusätzlich in einem strichlierten Linienzug der Phasenwinkel $\varphi31'$ eingezeichnet, der sich für die Oszillatorschaltung nach Fig. 2 mit zusätzlichem Serienresonanzkreis ergibt. Dieser Kurvenzug zeigt einen über einen bestimmten Frequenzbereich konstanten Phasenwinkel.

Mit der erfindungsgemäßen Schaltung läßt sich eine sehr hohe Oszillatorfrequenz (beispielsweise 3 GHz) in einfacher Weise auf solche Frequenzwerte herunterteilen, die mit üblichen Frequenzteilern gut beherrschbar sind. An eine Schaltung der vorstehend beschriebenen Art kann dann, gegebenenfalls unter Zwischenschaltung eines Trennverstärkers, ein Digitalteiler mit einer entsprechenden Anzahl von Teilerstufen angeschaltet werden.

**Patentansprüche**

1. Frequenzteiler für den Bereich sehr kurzer elektromagnetischer Wellen mit einem oberwellensynchronisierten Oszillator mit einem verstärkenden Halbleiterelement (Tr), dadurch gekennzeichnet, daß im Rückkopplungsweg vom Ausgang zum Eingang des Verstärkerelements (Tr) ein mit einem Koppelkondensator (C$_K$) in Reihe geschaltetes Leitungsstück (K) solcher Länge (l) eingeschaltet ist, daß bei der geteilten Frequenz die Phasendrehung der rückgekoppelten Schwingung durch das Verstärkerelement (Tr) auf einen Wert von 360° ergänzt wird, und im Ausgangskreis des Verstärkerelementes (Tr) ein Serienresonanzkreis (L1, C1) eingeschaltet ist, dessen Resonanzfrequenz etwa in Bandmitte der geteilten Frequenz liegt.

2. Frequenzteiler nach Anspruch 1, dadurch gekennzeichnet, daß das Verstärkerelement (Tr) ein in Emittergrundschaltung geschalteter bipolarer Transistor ist.

3. Frequenzteiler nach Anspruch 1, dadurch gekennzeichnet, daß das Verstärkerelement (Tr) ein in Source-Grundschaltung geschalteter Feldeffekttransistor (FET) ist.

**Claims**

1. A frequency divider for very short wavelength electro-magnetic waves, with an oscillator whose harmonics are synchronised and which has an amplifying semiconductor element (Tr), characterised in that there is inserted into the feedback path from the output to the input of the amplifier element (Tr) a line portion (K) connected in series with a coupling capacitor (C$_K$) and which is of such length (1), that in the case of the divided frequency the phase rotation of the fed-back oscillation is supplemented to a value of 360° by the amplifier element (Tr), and there is inserted into the output circuit of the amplifier element (Tr) a series resonance circuit (L1, C1) whose resonant frequency lies approximately in the centre of the band of the divided frequency.

2. A frequency divider as claimed in Claim 1, characterised in that the amplifier element (Tr) is a bipolar transistor in a grounded emitter configuration.

3. A frequency divider as claimed in Claim 1, characterised in that the amplifier element (Tr) is a field-effect transistor (FET) in a grounded source configuration.

**Revendications**

1. Diviseur de fréquence pour la gamme d'ondes électromagnétiques très courtes, comportant un oscillateur synchronisé sur des harmoniques qui comporte un élément amplificateur (Tr) à semiconducteurs, caractérisé par le fait que dans le circuit de réaction allant de la sortie à l'entrée de l'élément amplificateur (Tr) est insérée une section de ligne (K), montée en série avec un condensateur de couplage (C$_K$), de longueur (l) telle que pour la fréquence divisée la rotation de phase de l'oscillateur renvoyée est complétée jusqu'à une valeur de 360°, par l'élément amplificateur (Tr), et dans le circuit de sortie de l'élément amplificateur (Tr) est inséré un circuit résonant série (L1, C1) dont la fréquence de résonance se trouve sensiblement au centre de la bande de la fréquence divisée.

2. Diviseur de fréquence suivant la revendication 1, caractérisé par le fait que l'élément amplificateur (Tr) est un transistor bipolaire branché suivant un montage en émetteur commun.

3. Diviseur de fréquence suivant la revendication 1, caractérisé par le fait que l'élément amplificateur (Tr) est un transistor à effet de champ (FET) branché suivant un montage en source commune.

# FIG 1

$$\frac{1}{N} \cdot f_{RF}$$

# FIG 2

$$\frac{1}{N} \cdot f_{RF}$$

# FIG 3

# FIG 4